(19) **Europäisches Patentamt / European Patent Office / Office européen des brevets**

(11) **EP 3 187 619 B1**

(12) # EUROPEAN PATENT SPECIFICATION

(45) Date of publication and mention
of the grant of the patent:
**14.08.2019 Bulletin 2019/33**

(51) Int Cl.:
*C23C 14/34* (2006.01)    *H01J 37/34* (2006.01)
*C22C 1/04* (2006.01)    *C22C 9/00* (2006.01)
*C22C 28/00* (2006.01)    *C22F 1/00* (2006.01)

(21) Application number: **15834975.3**

(22) Date of filing: **28.08.2015**

(86) International application number:
**PCT/JP2015/074465**

(87) International publication number:
**WO 2016/031974 (03.03.2016 Gazette 2016/09)**

(54) **Cu-Ga SPUTTERING TARGET AND PRODUCTION METHOD FOR Cu-Ga SPUTTERING TARGET**

CU-GA-SPUTTERTARGET UND VERFAHREN ZUR HERSTELLUNG DES
CU-GA-SPUTTERTARGETS

CIBLE DE PULVÉRISATION CATHODIQUE EN Cu-Ga ET PROCÉDÉ DE PRODUCTION POUR
CIBLE DE PULVÉRISATION CATHODIQUE EN Cu-Ga

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.08.2014 JP 2014174539
27.08.2015 JP 2015167676**

(43) Date of publication of application:
**05.07.2017 Bulletin 2017/27**

(73) Proprietors:
• **Mitsubishi Materials Corporation**
**Chiyoda-ku**
**Tokyo 100-8117 (JP)**
• **Solar Frontier K.K.**
**Minato-ku**
**Tokyo 135-8074 (JP)**

(72) Inventors:
• **UMEMOTO Keita**
**Sanda-shi**
**Hyogo 669-1339 (JP)**

• **ZHANG Shoubin**
**Sanda-shi**
**Hyogo 669-1339 (JP)**
• **IO Kensuke**
**Sanda-shi**
**Hyogo 669-1339 (JP)**

(74) Representative: **Hoffmann Eitle**
**Patent- und Rechtsanwälte PartmbB**
**Arabellastraße 30**
**81925 München (DE)**

(56) References cited:
**WO-A1-2011/083646    WO-A1-2011/083647
WO-A1-2011/083647    JP-A- H1 074 967
JP-A- 2007 266 626    JP-A- 2009 283 560
US-A1- 2012 217 157**

• **EDITOR-IN-CHIEF THADDEUS MASSALSKI:
"Binary Alloy Phase Diagrams Volume 2,
PASSAGE", BINARY ALLOY PHASE DIAGRAMS,
AMERICAN SOCIETY OF METALS, US, vol. 2, 1
January 1990 (1990-01-01), pages 1410-1412,
XP002468139,**

**Description**

Technical Field

The present invention relates to a Cu-Ga sputtering target, which is used in the formation of a Cu-In-Ga-Se quaternary alloy thin film, to be the light-absorbing layer of the CIGS solar cell, and a method for producing the Cu-Ga sputtering target.

Background Art

Conventionally, the CIGS solar cell, which has the light-absorbing layer made of the Cu-In-Ga-Se quaternary alloy thin film, is provided as a thin film solar cell made of the compound semiconductor.

As a method for forming the light-absorbing layer made of the Cu-In-Ga-Se quaternary alloy thin film, a method in which deposition is performed by a vapor deposition method is known. The solar cell having the light-absorbing layer deposited by the vapor deposition method has advantages since the solar cell has high energy conversion efficiency. However, it is not suitable for enlarging the area of the solar cell, and has a problem of low production efficiency.

Thus, a method, in which the light-absorbing layer made of the Cu-In-Ga-Se quaternary alloy film is formed by a sputtering method, is proposed.

In the sputtering method, first, an In film is deposited by using an In target. Then, by forming a Cu-Ga film on the In film by using a Cu-Ga sputtering target, a laminated film of the In film and the Cu-Ga film is formed. Then, a Cu-In-Ga-Se quaternary alloy film is formed by heat treating the laminated film in Se atmosphere to perform selenization on the above-described laminated film.

It is known that the conversion efficiency of the solar cell improves by adding alkaline metal such as sodium and the like in the Cu-In-Ga-Se quaternary alloy thin film to be the light-absorbing layer.

As a method to add the alkaline metal to the Cu-In-Ga-Se quaternary alloy thin film, methods, in which the alkaline metal is added to the Cu-Ga sputtering target used during depositing the Cu-Ga film, are disclosed in Patent Literatures 1 and 2 (PTLs 1 and 2), for example.

The alkaline metal has extremely high reactivity and is unstable as an elemental substance. Thus, in the Cu-Ga sputtering target described in PTLs 1 and 2, it is added as an alkali metal compound. Specifically, $Li_2O$, $Na_2O$, $K_2O$, $Li_2S$, $Na_2S$, $K_2S$, $Li_2Se$, $Na_2Se$, and $K_2Se$ are added in PTL 1. Particularly, it is described that addition of a Se compound is preferable. Addition of the alkali metal compound in the form of NaF is described in PTL 2.

Citation List

Patent Literature

   PTL 1: Republished Japanese Translation No. WO2011/083647 (A) of the PCT international Publication for Patent Application
   PTL 2: Japanese Patent (Granted) Publication No. 4793504 (B)

Summary of Invention

Technical Problem

Recently, there is demand for further improvement of the conversion efficiency in the solar cell; and it is needed to include the alkaline metal to the Cu-In-Ga-Se quaternary alloy thin film at a higher concentration than before. In other words, in the Cu-Ga sputtering targets described in PTLs 1 and 2, contents of the alkaline metal were lesser; and improvement of the conversion efficiency was insufficient.

As a simple solution, adding the alkali metal compound to the Cu-Ga sputtering target in a larger amount of than before can be considered. However, the alkali metal compound is basically an insulating material; and simply increasing its content will cause abnormal discharge. Accordingly, it is possible that the Cu-Ga film cannot be deposited stably. In addition, it is possible that the alkaline metal cannot be evenly dispersed in the deposited Cu-Ga film. Therefore, it is difficult to form the Cu-In-Ga-Se quaternary alloy thin film including much more of the alkaline metal.

The present invention is made under the circumstances explained above. The purpose of the present invention is to provide: a Cu-Ga sputtering target, which contains the alkali metal compound in a relatively larger amount and is capable of depositing stably a Cu-Ga film having a composition in which alkaline metal is evenly dispersed; and a method of producing the Cu-Ga sputtering target.

Solution to Problem

The present invention includes the following aspects in order to solve the above-described problems.
An aspect of the present invention is a Cu-Ga sputtering target (hereinafter, referred as "the Cu-Ga sputtering target of the present invention") made of a composition consisting of: as metal components excluding fluorine, 5 atomic% or more and 60 atomic% or less of Ga and 0.01 atomic% or more and 5 atomic% or less of K; and the Cu balance containing inevitable impurities, wherein the Cu-Ga sputtering target has a region containing Cu, Ga, K, and F, in an atomic mapping image by a wavelength separation X-ray detector (hereinafter, referred as "Cu-Ga-K-F region").
The Cu-Ga-K-F region is a single-phased crystal grain or grain boundary. The Cu-Ga-K-F region is a region in which the presence of Cu, Ga, K, and F is confirmed in the atomic mapping image by the wavelength separation X-ray detector. In the wavelength separation X-ray detector, the presence of Cu, Ga, K, and F is detected by the characteristic X-ray. "Containing Cu, Ga, K, and F" means that: 5 mass% or more of Cu; 5 mass% or more of Ga; 5 mass% or more of K; and 5 mass% or more of F, are detected in the quantitative map image created by using ZAF correction method. In creating the quantitative map, C, O, F, K, Cu, and Ga are chosen as constituent elements.
In the Cu-Ga sputtering target of the present invention configured as described above, the Cu-Ga film containing K, which is an alkaline metal, in a relatively larger amount can be deposited, since the Cu-Ga sputtering target is made of a composition containing: as metal components excluding fluorine, 5 atomic% or more and 60 atomic% or less of Ga and 0.01 atomic% or more and 5 atomic% or less of K; and the Cu balance containing inevitable impurities.
In addition, the abnormal discharge during sputtering can be suppressed; and the Cu-Ga film in which the alkaline metal, K is evenly dispersed can be stably deposited, since at least a part of the alkaline metal, K exists as the Cu-Ga-K-F region containing Cu, Ga, K, and F in the sputtering target.
In the Cu-Ga sputtering target of the present invention, the region containing Cu, Ga, K, and F may have a compound phase of: K; one of or both of Cu and Ga; and F.
In this case, K in the above-described region containing Cu, Ga, K, and F is in the form of a compound phase with metal. Thus, electro conductivity of the Cu-Ga-K-F region increases; and the abnormal discharge during sputtering can be reduced.
In addition, in the Cu-Ga sputtering target of the present invention, the region containing Cu, Ga, K, and F may disperse in a grain boundary of a Cu-Ga matrix.
In this case, the above-described region containing Cu, Ga, K, and F widely disperses in the entire Cu-Ga sputtering target. Thus, the Cu-Ga film, in which the alkaline metal, K is evenly dispersed, can be reliably deposited.
In addition, in the Cu-Ga sputtering target of the present invention, the Cu-Ga matrix may include a KF single phase, and an abundance ratio X of the KF single phase relative to an entire amount of KF in the Cu-Ga sputtering target may be 0%<X≤70%. The abundance ratio X is the value obtained from the formula (the KF single phase)/((the KF single phase)+(the Cu-Ga-K-F region))×100.
In this case, the abundance ratio of the KF single phase is kept 70% or less. Thus, the abnormal discharge during sputtering can be reduced even under high output electrical power; and the Cu-Ga film, in which the alkaline metal, K is evenly dispersed, can be deposited stably and reliably.
Other aspect of the present invention is a Cu-Ga sputtering target production method for producing the above-described Cu-Ga sputtering target (hereinafter, referred as "the Cu-Ga sputtering target production method of the present invention"), the method including the step of sintering a raw material powder by heating, wherein the raw material powder is a mixed powder, in which: a first Cu-Ga alloy powder containing 43 atomic% or more and 66 atomic% or less of Ga forming a liquid phase component in the step of sintering; a KF raw material powder; and one of or both of a second Cu-Ga alloy powder containing more than 0 atomic% and less than 43 atomic% of Ga not forming a liquid phase component in the step of sintering and a Cu powder, are mixed so as to obtain a composition containing: as metal components excluding fluorine, 5 atomic% or more and 60 atomic% or less of Ga and 0.01 atomic% or more and 5 atomic% or less of K; and the Cu balance containing inevitable impurities, and a Cu-Ga-K-F region containing Cu, Ga, K, and F is formed by liquid phase sintering a part of the raw material powder in the step of sintering.
In the Cu-Ga sputtering target production method of the present invention configured as described above, the Cu-Ga-K-F region containing Cu, Ga, K, and F can be formed by having the Cu-Ga alloy in the liquid phase and the KF raw material powder react each other, since the raw material powder is the mixed powder, in which: a first Cu-Ga alloy powder forming a liquid phase component in the step of sintering; a KF raw material powder; and one of or both of a second Cu-Ga alloy powder not forming a liquid phase component in the step of sintering and a Cu powder, are mixed; and a part of the raw material powder is liquid sintered in the step of sintering.
In the Cu-Ga sputtering target production method of the present invention, an oxygen concentration of the first Cu-Ga alloy powder may be 1000 ppm or less.
In this case, since the oxygen concentration of the first Cu-Ga alloy powder is kept to 1000 ppm or less, the liquid phase can be formed reliably by melting the first Cu-Ga alloy powder. Accordingly, the Cu-Ga-K-F region containing Cu, Ga, K, and F can be formed reliably.

In addition, in the Cu-Ga sputtering target production method of the present invention, an average grain size of the first Cu-Ga alloy powder in the raw material powder may be in a range of 5 μm or more and 50 μm or less; and an average grain size of the KF raw material powder may be in the range of 5 μm or more and 500 μm or less.

In this case, since each of the average grain size of the first Cu-Ga alloy powder and the average grain size of the KF raw material powder is defined in each of the above-described ranges, the Cu-Ga-K-F region containing Cu, Ga, K, and F can be formed by having the liquid phase produced from the first Cu-Ga alloy powder and the KF raw material powder react each other reliably.

In addition, in the Cu-Ga sputtering target production method of the present invention, the raw material powder may be kept at a temperature, at which a liquid phase is formed from the first Cu-Ga alloy powder, for 15 minutes or more in the step of sintering.

In this case, time for the liquid phase produced from the first Cu-Ga alloy powder and the KF raw material powder contacting each other to react can be secured. Accordingly, the Cu-Ga-K-F region containing Cu, Ga, K, and F can be formed reliably.

Advantageous Effects of Invention

As described above, according to the present invention, a Cu-Ga sputtering target, which contains the alkali metal compound in a relatively larger amount and is capable of depositing stably a Cu-Ga film having a uniform composition; and a method of producing the Cu-Ga sputtering target, can be provided.

Brief Description of Drawings

FIG. 1 is a flowchart showing the Cu-Ga sputtering target production method related to an embodiment of the present invention.
FIG. 2 is an example of elemental mapping of Cu, Ga, K, and F of the Cu-Ga sputtering target observed in Example of the present invention.

Description of Embodiments

The Cu-Ga sputtering target and the Cu-Ga sputtering target production method, both of which are embodiments of the present invention, are explained below in reference to the attached drawings.

The Cu-Ga sputtering target related to the present embodiment is used during depositing the Cu-Ga thin film by sputtering in order to form the light-absorbing layer made of the Cu-In-Ga-Se quaternary alloy thin film in the CIGS thin film solar cell, for example.

In the Cu-Ga sputtering target related to the present embodiment, KF (potassium fluoride) is added to the Cu-Ga alloy; and the Cu-Ga sputtering target related to the present embodiment has a composition containing: as metal components excluding fluorine, 5 atomic% or more and 60 atomic% or less of Ga and 0.01 atomic% or more and 5 atomic% or less of K; and the Cu balance containing inevitable impurities.

The alkaline metal, K is included in the deposited Cu-Ga thin film by the Cu-Ga sputtering target, and the element having the effect of improving the conversion efficiency of the CIGS thin film solar cell. In the present embodiment, K is included at a relatively high amount of 0.01 atomic% or more and 5 atomic% or less.

The Cu-Ga sputtering target has the Cu-Ga matrix, the Cu-Ga-K-F region containing Cu, Ga, K, and F and the KF single phase.

The Cu-Ga-K-F region containing Cu, Ga, K, and F is formed by having: KF; and Cu and Ga, react each other. In the present embodiment, the Cu-Ga-K-F region has a compound phase of: K; one of or both of Cu and Ga; and F, and disperses in the grain boundary of the Cu-Ga matrix.

A preferable area ratio of the Cu-Ga-K-F region is 5% to 80% in the atomic mapping image by the wavelength separation X-ray detector in any cross section of the Cu-Ga sputtering target related to the present embodiment. A more preferable area ratio of the Cu-Ga-K-F region is 10% to 50%. An even more preferable area ratio of the Cu-Ga-K-F region is 20% to 30%. The area ratio of the Cu-Ga-K-F region means the area ratio of the Cu-Ga-K-F region relative to the entire area of the observed area.

In addition, in the Cu-Ga sputtering target of the present embodiment, the Cu-Ga matrix includes the KF single phase, and the abundance ratio X of the KF single phase relative to the entire amount of KF in the Cu-Ga sputtering target is set to the range of 0%<X≤70%.

The abundance ratio of the KF single phase is limited to 70% or less in order to suppress the abnormal discharge when the sputtering target includes alkaline metal, K in a relatively larger amount.

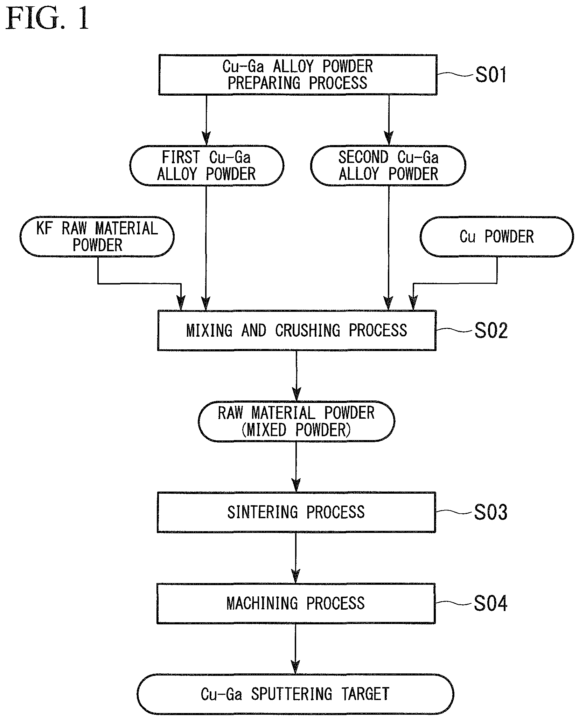

Next, the Cu-Ga sputtering target production method related to the present embodiment is explained in reference to the flowchart shown in FIG. 1.

The Cu-Ga sputtering target production method related to the present embodiment includes: the Cu-Ga alloy preparing process S01, in which the after-mentioned first and second Cu-Ga alloy powders are prepared; the mixing and crushing process S02, in which the raw material powder is obtained by mixing and crushing the first Cu-Ga alloy powder and the second Cu-Ga alloy powder, the KF raw powder, and the Cu powder; the sintering process S03, in which sintering is performed by heating the raw material powder; and the machining process S04, in which the obtained sintered material is machined, as shown in FIG. 1.

The raw material powder is the mixed powder, in which: the KF raw material powder; the first Cu-Ga alloy powder forming the liquid phase component at the sintering temperature in the sintering process (at 50°C or more and 300°C or less in the present embodiment); and one of or both of the second Cu-Ga alloy powder not forming the liquid phase component in the above-described sintering process and the Cu powder, are mixed.

The purity of the KF raw material powder is set to 99.9 mass% or more; and the average grain size of the KF raw material powder is set to the range of 5 $\mu$m or more and 500 $\mu$m or less.

The first Cu-Ga alloy powder is the atomized powder having the composition of: 43 atomic% or more and 66 atomic% or less of Ga; and the Cu balance containing inevitable impurities; and the average grain size of the first Cu-Ga alloy powder is set to the range of 5 $\mu$m or more and 50 $\mu$m or less.

In addition, in the first Cu-Ga alloy powder, the oxygen concentration is set to 1000 ppm or less in mass ratio. Preferably, it is set to 200 ppm or less.

The second Cu-Ga alloy powder is the atomized powder having the composition of: more than 0 atomic% and less than 43 atomic% of Ga; and the Cu balance containing inevitable impurities; and the average grain size of the second Cu-Ga alloy powder is set to the range of 5 $\mu$m or more and 50 $\mu$m or less.

In addition, in the Cu powder, the purity is set to 99.9 mass% or more; and the average grain size is set to the range of 5 $\mu$m or more and 50 $\mu$m or less.

[Cu-Ga alloy powder preparation process S01]

The above-described first and second Cu-Ga alloy powders are prepared by procedures explained below.

First, the massive form Cu raw material and Ga material are weighted to obtain a predetermined composition, and inserted in a crucible made of carbon to set in a gas atomization device. After vacuum evacuating and melting the raw material at the temperature condition of 1000°C or more and 1200°C or less for 1 minutes or more and 30 minutes or less, the gas atomize powder is prepared by ejecting Ar gas in the condition of 10kgf/cm$^2$ or more and 50kgf/cm$^2$ or less of the injection gas pressure, while the melt is dropped form the nozzle having the diameter of 1mm or more and 3mm or less. After cooling, the obtained atomized powder is subjected to classification with the sieve of 90-500 $\mu$m; and the first Cu-Ga alloy powder and the second Cu-Ga alloy powder having predetermined grain sizes are obtained.

In producing the first Cu-Ga alloy powder, the oxygen concentration is reduced to 1000 ppm or less, preferably to 200 rpm or less, by setting the degree of vacuum to 1Pa or less during vacuum evacuating.

In addition, depending on the composition ratio between Cu and Ga, it is possible that the melt reaches to the chamber before solidifying to be powder due to too high ejection temperature. In this case, it is preferable that atomization is performed at the ejection temperature 100°C to 400°C lower than the hot retention temperature.

[Mixing and crushing process S02]

Next, the above-described KF raw material powder, the first Cu-Ga alloy powder, the second Cu-Ga alloy powders, and the Cu powder are weighted to obtain a predetermined composition. Then, they are mixed and crushed by using the mixing pulverizer to obtain the raw material powder. When the ball mill is used as the mixing pulverizer, it is preferable that 5 kg of zirconia made balls of $\phi$5mm, and 3 kg of the raw material powder (the KF raw material powder, the first Cu-Ga alloy powder, the second Cu-Ga alloy powders, and the Cu powder) in total are placed in a 10-L pot filled an inert gas such as Ar, for example; and the ball mill is operated at 85 rpm for 16 hours. In addition, when the Henschel mill is used as the mixing pulverizer, it is preferable that the Henschel mill is operated at the rotation speed of 2800 rpm for 5 minutes in inert gas atmosphere such as Ar, for example. Mixing-based mixing pulverizer such as the V type mixer, the rocking mixer, and the like is not preferable since it is possible that crushing of the KF raw material powder becomes insufficient.

[Sintering process S03]

Next, sintering of the raw material powder (the mixed powder) obtained as described above is performed in vacuum, inert gas atmosphere, or reducing atmosphere. It is preferable to set the sintering temperature in the sintering process depending on the melting temperature Tm of the producing Cu-Ga alloy. Specifically, it is preferable that the sintering temperature is set to the range of (Tm-70)°C or more and (Tm-20)°C or less. In addition, it is preferable to retain the raw material powder in the temperature range of 250°C or more and 300°C or less corresponding to the temperature, in which the first Cu-Ga alloy powder is melted for the liquid phase to be formed (the liquid phase temperature of the first Cu-Ga alloy powder) in the temperature profile during sintering, for 15 minutes or more.

In this sintering process S03, a part of the first Cu-Ga alloy powder is melted for the liquid phase to be formed. By having the liquid phase and the KF raw material powder react each other, the Cu-Ga-K-F region containing Cu, Ga, K, and F is formed.

In the sintering process S03, pressureless sintering; hot pressing; or hot isostatic pressing can be used as a sintering method.

When pressureless sintering is used, it is advantageous to use carbon monoxide (CO), hydrogen, ammonia cracking gas, or the like in sintering as reducing gas. In addition, it is preferable that the content of the reducing gas in the atmosphere is 1 volume% or more.

In addition, when hot pressing or hot isostatic pressing is used, it is preferable that the pressure condition is set to the range of 10MPa or more and 60MPa or less, since the pressure condition influences on the density of the sintered material. Pressing can be done before the beginning of heating. Alternatively, pressing can be done after reaching to a constant temperature.

[Machining process S04]

By performing cutting work or grinding work on the sintered material obtained in the sintering process S03, it is machined into a sputtering target in a predetermined shape. Since KF dissolve in water, it is preferable to use dry method not using coolant liquid in the machining process S04.

By following the above-described processes, the Cu-Ga sputtering target of the present embodiment is produced. This Cu-Ga sputtering target is used after bonded on a backing plate, which is made of Cu, SUS (stainless), or other metal (for example, Mo), using In as soldering material.

According to the Cu-Ga sputtering target of the present embodiment configured as described above, the Cu-Ga film containing the alkaline metal, K can be deposited, since KF (potassium fluoride) is added to the Cu-Ga alloy; and the Cu-Ga sputtering target has the composition containing: as metal components excluding fluorine, 5 atomic% or more and 60 atomic% or less of Ga and 0.01 atomic% or more and 5 atomic% or less of K; and the Cu balance containing inevitable impurities. Thus, a high quality CIGS thin film solar cell having excellent conversion efficiency can be constructed.

In addition, in the Cu-Ga sputtering target of the present embodiment, at least a part of the alkaline metal, K is included in the form of the Cu-Ga-K-F region containing Cu, Ga, K, and F. Thus, the abnormal discharge during sputtering can be suppressed; and the Cu-Ga film can be deposited stably.

In the Cu-Ga sputtering target production method of the present embodiment, the liquid phase is produced by melting at least part of the first Cu-Ga alloy powder in the sintering process S03. Thus, the Cu-Ga alloy in the liquid phase and the KF raw material powder react each other; and the Cu-Ga-K-F region containing Cu, Ga, K, and F can be formed. Thus, as described above, the Cu-Ga sputtering target, which is capable of depositing stably the Cu-Ga film in which the alkaline metal, K is uniformly dispersed, can be obtained.

In addition, in the present embodiment, the oxygen concentration of the first Cu-Ga alloy powder is limited to 1000 ppm, preferably to 200 ppm. Thus, at least a part of the first Cu-Ga alloy powder can be melted reliably for the liquid phase to be produced; and the Cu-Ga-K-F region containing Cu, Ga, K, and F can be formed reliably.

Moreover, in the present embodiment, the raw material powder is retained at the temperature, in which the liquid phase is produced from the first Cu-Ga alloy powder in the temperature profile in the sintering process S03, for 15 minutes or more. Thus, time for the liquid phase produced from the first Cu-Ga alloy powder and the KF raw material powder contacting each other to react can be secured; and the Cu-Ga-K-F region containing Cu, Ga, K, and F can be formed reliably.

In addition, in the present embodiment, the average grain size of the first Cu-Ga alloy powder in the raw material powder is set to the range of 5 μm or more and 50 μm or less; and the average grain size of the KF raw material powder is set to the range of 5 μm or more and 500 μm or less. Thus, the Cu-Ga-K-F region containing Cu, Ga, K, and F can be formed by having the first Cu-Ga alloy powder and the KF raw material powder react each other reliably.

Embodiments of the present invention are explained above. However, the present invention is not limited by the explanation, and can be modified suitably to the extent not deviating from the scope of the present invention.

For example, in the present embodiment, the raw material powder is explained as the mixed powder, in which the first Cu-Ga alloy powder; the KF raw material powder; the second Cu-Ga alloy powder; and the Cu powder. The present invention is not limited by the description. In terms of the second Cu-Ga alloy powder and the Cu powder, the raw material powder may include at least one of the second Cu-Ga alloy powder and the Cu powder; and it can be configured suitably depending on the composition of the Cu-Ga sputtering needed.

Examples

Test results in evaluating the effects of the Cu-Ga sputtering target related to the present invention are explained below.

[Cu-Ga sputtering target]

First, the Cu-Ga alloy powder, the Cu powder and the KF raw material powder, all of which were ingredients of the raw material powder, were prepared. In Examples 1-14 of the present invention and Comparative Example 5, the first Cu-Ga alloy powder, which produced the liquid phase in the sintering process, was used. The method of producing the first Cu-Ga alloy powder is shown in Table 1.
The Cu-Ga sputtering targets having the compositions shown in Table 4 were produced by setting the blending composition of the raw material powder as shown in Table 2; and following the production conditions shown in Table 3.
Texture observation was performed on the obtained Cu-Ga sputtering targets; and occurrence of the abnormal discharge was evaluated as explained below. The evaluation results are shown in Table 4.

[Identification of the Cu-Ga-K-F region and the KF single phase]

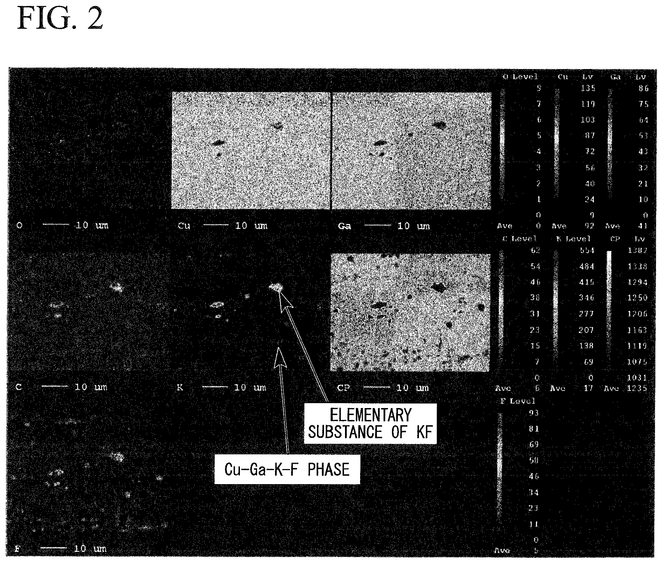

The atomic mapping image can be obtained by the wavelength separation X-ray detector. In the present examples, the atomic mapping image of the cross section of the Cu-Ga sputtering target was obtained by the method explained below by using the electron probe micro analyzer (EPMA) device.
Cross section polisher processing (CP processing) was performed on the processed surface of the produced Cu-Ga sputtering target; and the electron mapping image of Cu, Ga, K, and F was obtained with the electron probe micro analyzer (EPMA) device (Model JXA-8500F manufactured by JOEL Ltd.). The region in which only K and F existed was defined as the KF single phase. The region in which Cu, Ga, K, and F were detected was defined as the Cu-Ga-K-F region. In terms of judging detection of Cu, Ga, K, and F, the element was regarded as being detected when: the Cu content was 5 mass% or more in the case of Cu; the Ga content was 5 mass% or more in the case of Ga; the K content was 5 mass% or more in the case of K; and the F content was 5 mass% or more in the case of F, in the quantitative map image created by using ZAF correction method. In creating the quantitative map, C, O, F, K, Cu, and Ga were chosen as constituent elements. An example of the element mapping image is shown in FIG. 2. The location, in which the Cu-Ga-K-F region existed, is shown in Table 4. When the Cu-Ga-K-F existed: in the grain boundary of Cu-Ga phases as shown in FIG. 2; or in both of the grain and the grain boundary of Cu-Ga phases, the location of the Cu-Ga-K-F region was defined as "in grain boundary." When the Cu-Ga-K-F region only existed in the grain of the Cu-Ga phase, the location of the Cu-Ga-K-F was defined as "in grain."
The measurement condition by EPMA device was as described below.

Measurement magnification: 500-times
Pixel size: 1 $\mu$m
Sampling time: 10 m sec
Electric current: 50 nA
Acceleration voltage: 15 kV
Characteristic X-ray used in mapping: C: K$\alpha$-ray, O: K$\alpha$-ray, F: K$\alpha$-ray, K: K$\alpha$-ray, Cu: K$\alpha$-ray, Ga: L$\alpha$-ray
Software for creating map: JXA-8500F vol. 42

[Identification of the compound phase of: K; one of or both of Cu and Ga; and F]

The presence or absence of the compound phase of: K; one of or both of Cu and Ga; and F, as the Cu-Ga-K-F region was evaluated by the procedure described below.
Cross section polisher processing (CP processing) was performed on the processed surface of the produced Cu-Ga sputtering target; the spectrum of the 2p orbital, which corresponded to the spectrum from 280 to 305 eV, was measured after performing surface etching by Ar for 1 minute with the X-ray photoelectron spectrometer (XPS) (manufactured by Physical Electronics). When there was a detected peak from 296 to 297 eV in the above-described K spectrum, it was defined as "Present." When there was no peak from 296 to 297 eV in the above-described K spectrum, it was defined as "Absent." Results are shown in Table 4.

The measurement condition by XPS device was as described below.

Radiation source: A1 K$\alpha$-ray, 350 W
Measurement area: $\phi$800 $\mu$m
Path energy: 187.85 eV
Measurement interval: 0.8 eV/step
Photoelectron extraction angle with respect to the sample surface: 45 deg

[Abundance ratio of the KF single phase]

The abundance ratio of the KF single phase was calculated from the equation shown below after performing image processing on the mapping image of K among the above-described element mapping and obtaining each area of the Cu-Ga-K-F region and the KF single phase. As an image processing software, WinRoof (manufactured by Mitani Co.) can be used, for example.

$$\text{(area of the KF single phase)}/((\text{area of the KF single phase})+(\text{area of Cu-Ga-K-F region}))\times 100$$

[Measurement of uniformity of K in the sputtered film]

Deposition by sputtering was performed using the produced Cu-Ga sputtering target in the condition described below. A sputtered film was deposited in 1 $\mu$m thickness on the alkaline-free glass substrate having the dimension of 100 mm$\times$100 mm: by using the DC magnetron sputtering device and Ar gas as the sputtering gas, in the condition of: 50sccm of the flow rate; 0.67Pa of the pressure; and 2W/cm$^2$ of the input electrical power.

The obtained films were analyzed by the fluorescence X-ray analyzer (XRF). Measurements of Cu, Ga, and K were performed on five locations on the coordinates of (-20 mm, +20 mm); (+20 mm, +20 mm); (-20 mm, -20 mm); (+20 mm, -20 mm); and (0 mm, 0 mm), the center of the substrate being the location of (X=0, Y=0). For the measurements, Primus II manufactured by Rigaku Co. was used. The value, in which the minimum value among the five points was subtracted from the maximum value among the five points, was calculated on the obtained values of K content.

[Abnormal discharge during sputtering]

By using the produced Cu-Ga sputtering target, deposition by sputtering was performed in the condition described below. Sputtering was performed for 30 minutes under two different electrical power settings, one of which was the input electrical power was 2W/cm$^2$ (low electrical power setting), and another of which was the input electrical power was 5W/cm$^2$ (high electrical power setting): by using the DC magnetron sputtering device and Ar gas as the sputtering gas, in the condition of: 50sccm of the flow rate; and 0.67Pa of the pressure. The number of occurrence of the abnormal discharge was counted by the arcing count function provided on the DC power supply.

In the present examples, as the electrical power supply, RPG-50 (manufactured by mks Co.) was used, for example.

[Table 1]

| | | First Cu-Ga alloy powder producing the liquid component | | | | Second Cu-Ga alloy powder not producing the liquid component | | | Cu powder | | KF powder | |
|---|---|---|---|---|---|---|---|---|---|---|---|---|
| | | Ga content (at%) | Oxygen concentration (wt%) | Average grain size (μm) | Blending ratio (%) | Ga content (at%) | Average grain size (μm) | Blending ratio (%) | Average grain size (μm) | Blending ratio (%) | Average grain size (μm) | Blending ratio (%) |
| Example of the present invention | 1 | 50 | 0.008 | 7.8 | 50.0 | 20 | 7.6 | 15.0 | 53.6 | 34.6 | 6 | 0.4 |
| | 2 | 60 | 0.013 | 10.3 | 41.7 | - | - | - | 25.1 | 56.8 | 112 | 1.5 |
| | 3 | 60 | 0.007 | 35.7 | 33.3 | - | - | - | 53.6 | 66.5 | 6 | 0.1 |
| | 4 | 45 | 0.011 | 45.7 | 22.2 | - | - | - | 53.6 | 76.6 | 53 | 1.2 |
| | 5 | 50 | 0.028 | 10.2 | 70.0 | - | - | - | 25.1 | 28.5 | 112 | 1.5 |
| | 6 | 60 | 0.057 | 15.8 | 66.7 | - | - | - | 25.1 | 28.9 | 230 | 4.5 |
| | 7 | 50 | 0.076 | 20.5 | 60.0 | - | - | - | 25.1 | 39.0 | 12 | 1.0 |
| | 8 | 60 | 0.008 | 5.2 | 55.0 | - | - | - | 53.6 | 44.6 | 112 | 0.4 |
| | 9 | 50 | 0.010 | 30.7 | 50.0 | - | - | - | 20.6 | 45.5 | 230 | 4.5 |
| | 10 | 60 | 0.018 | 38.7 | 55.0 | 10 | 20.4 | 30.0 | 25.0 | 13.5 | 20 | 1.5 |
| | 11 | 60 | 0.015 | 20.5 | 48.3 | - | - | - | 20.6 | 45.7 | 430 | 5.9 |
| | 12 | 60 | 0.120 | 10.5 | 46.7 | - | - | - | 20.6 | 48.9 | 112 | 4.5 |
| | 13 | 60 | 0.009 | 57.8 | 50.0 | - | - | - | 53.6 | 49.3 | 53 | 0.7 |
| Comparative Example | 1 | - | - | - | - | 25 | 25.3 | 80.0 | 25.0 | 18.5 | 230 | 1.5 |
| | 2 | - | - | - | - | 30 | 23.5 | 93.3 | 20.6 | 2.2 | 112 | 4.5 |
| | 3 | - | - | - | - | 35 | 19.3 | 85.7 | 53.6 | 13.5 | 53 | 0.7 |
| | 4 | - | - | - | - | 40 | 13.2 | 87.5 | 20.6 | 2.1 | 757 | 10.4 |
| | 5 | 50 | 0.014 | 26.7 | 70.0 | - | - | - | 20.6 | 19.6 | 757 | 10.4 |

[Table 2]

| | | Production condition of the first Cu-Ga alloy powder producing the liquid phase component | | | | |
| | | Atomizing condition | | | | |
| | | Cu content (at%) | Ga content (at%) | Ultimate vacuum (Pa) | Melting temperature (°C) | Retention time (min) |
|---|---|---|---|---|---|---|
| Example of the present invention | 1 | 50 | 50 | 0.03 | 1200 | 5 |
| | 2 | 40 | 60 | 0.06 | 1100 | 10 |
| | 3 | 40 | 60 | 0.01 | 1050 | 10 |
| | 4 | 55 | 45 | 0.05 | 1100 | 5 |
| | 5 | 50 | 50 | 0.12 | 1200 | 5 |
| | 6 | 40 | 60 | 0.35 | 1050 | 10 |
| | 7 | 50 | 50 | 0.89 | 1100 | 5 |
| | 8 | 40 | 60 | 0.01 | 1050 | 5 |
| | 9 | 50 | 50 | 0.03 | 1200 | 5 |
| | 10 | 40 | 60 | 0.08 | 1100 | 5 |
| | 11 | 40 | 60 | 0.05 | 1050 | 10 |
| | 12 | 40 | 60 | 100 | 1100 | 5 |
| | 13 | 40 | 60 | 0.03 | 1200 | 5 |
| Comparative Example | 1 | The first Cu-Ga alloy powder producing the liquid phase component was not used | | | | |
| | 2 | The first Cu-Ga alloy powder producing the liquid phase component was not used | | | | |
| | 3 | The first Cu-Ga alloy powder producing the liquid phase component was not used | | | | |
| | 4 | The first Cu-Ga alloy powder producing the liquid phase component was not used | | | | |
| | 5 | 50 | 50 | 0.05 | 1050 | 10 |

[Table 3]

| | | Target production condition | | | | | | |
| | | Sintering condition | | | | | | |
| | | Method | Atmosphere | Pressure (MPa) | Reaction temperature (°C) | Retention time (min) | Sintering temperature (°C) | Retention time (h) |
|---|---|---|---|---|---|---|---|---|
| Example of the present invention | 1 | HIP | Vacuum | 60 | 290 | 5 | 770 | 1 |
| | 2 | Hot pressing | Vacuum | 20 | 320 | 10 | 780 | 3 |
| | 3 | HIP | Vacuum | 50 | 330 | 15 | 830 | 3 |
| | 4 | HIP | Vacuum | 60 | 270 | 10 | 920 | 2 |
| | 5 | Hot pressing | Vacuum | 18 | - | - | 720 | 1 |
| | 6 | Hot pressing | Vacuum | 20 | - | - | 500 | 5 |
| | 7 | Hot pressing | Vacuum | 20 | - | - | 720 | 3 |
| | 8 | Pressureless sintering | $H_2$ | - | 280 | 30 | 710 | 5 |
| | 9 | Pressureless sintering | CO | - | 280 | 5 | 780 | 10 |
| | 10 | HIP | Vacuum | 60 | 330 | 15 | 680 | 2 |
| | 11 | Hot pressing | Vacuum | 20 | 260 | 5 | 770 | 3 |
| | 12 | HIP | Vacuum | 50 | 260 | 3 | 770 | 2 |
| | 13 | Pressureless sintering | $H_2$ | - | 300 | 30 | 720 | 5 |
| Comparative Example | 1 | Hot pressing | Vacuum | 20 | - | - | 780 | 2 |
| | 2 | HIP | Vacuum | 50 | 290 | 3 | 770 | 2 |
| | 3 | Pressureless sintering | $H_2$ | - | 300 | 30 | 720 | 5 |
| | 4 | Hot pressing | Vacuum | 25 | - | - | 710 | 3 |
| | 5 | Hot pressing | Vacuum | 25 | 270 | 3 | 710 | 3 |

[Table 4]

| | | Composition of metal component (at%) | | | Cu-Ga matrix | Cu-Ga-K-F region | | | KF single phase | | Number of occurrence of the abnormal discharge | |
|---|---|---|---|---|---|---|---|---|---|---|---|---|
| | | Ga | K | Cu and inevitable impurities | Average grain size μm | Presence or absence | Existing location | Presence or absence of the compound phase | Abundance ratio % | Uniformity of K max-min wt% | Low electrical power count/ 30min | High electrical power count/ 30min |
| Example of the present invention | 1 | 28 | 0.3 | balance | 5.7 | present | in grain boundary | present | 19 | 0.03 | 0 | 0 |
| | 2 | 25 | 1.0 | balance | 8.5 | present | in grain boundary | present | 53 | 0.02 | 0 | 3 |
| | 3 | 20 | 0.1 | balance | 32.2 | present | in grain | present | 9 | 0.01 | 0 | 0 |
| | 4 | 10 | 0.8 | balance | 42.6 | present | in grain boundary | present | 48 | 0.02 | 0 | 2 |
| | 5 | 35 | 1.0 | balance | 8.4 | present | in grain boundary | present | 64 | 0.03 | 2 | 10 |
| | 6 | 40 | 3.0 | balance | 9.5 | present | in grain boundary | present | 71 | 0.04 | 14 | 22 |
| | 7 | 30 | 0.7 | balance | 14.2 | present | in grain boundary | present | 89 | 0.03 | 6 | 8 |
| | 8 | 33 | 0.3 | balance | 3.6 | present | in grain boundary | present | 5 | 0.03 | 3 | 9 |
| | 9 | 25 | 3.0 | balance | 25.3 | present | in grain boundary | present | 21 | 0.04 | 4 | 14 |
| | 10 | 36 | 1.0 | balance | 34.1 | present | in grain boundary | present | 72 | 0.02 | 2 | 7 |
| | 11 | 29 | 4.0 | balance | 14.6 | present | in grain boundary | present | 65 | 0.05 | 16 | 24 |
| | 12 | 28 | 3.0 | balance | 5.7 | present | in grain boundary | absent | 90 | 0.04 | 8 | 25 |

(continued)

| | | Composition of metal component (at%) | | | Cu-Ga matrix | Cu-Ga-K-F region | | | KF single phase | Uniformity of K max-min wt% | Number of occurrence of the abnormal discharge | |
| | | Ga | K | Cu and inevitable impurities | Average grain size μm | Presence or absence | Existing location | Presence or absence of the compound phase | Abundance ratio % | | Low electrical power count/30min | High electrical power count/30min |
|---|---|---|---|---|---|---|---|---|---|---|---|---|
| | 13 | 30 | 0.5 | balance | 52.6 | present | in grain boundary | present | 87 | 0.04 | 2 | 19 |
| Comparative Example | 1 | 20 | 1.0 | balance | 8.3 | absent | - | absent | 100 | 0.10 | 53 | 142 |
| | 2 | 28 | 3.0 | balance | 5.7 | absent | - | absent | 100 | 0.04 | 78 | 235 |
| | 3 | 30 | 0.5 | balance | 52.6 | absent | - | absent | 100 | 0.04 | 33 | 109 |
| | 4 | 35 | 7.0 | balance | 22.3 | absent | - | absent | 100 | 0.12 | 85 | shut down |
| | 5 | 35 | 7.0 | balance | 22.3 | absent | - | absent | 100 | 0.05 | 53 | shut down |

In Comparative Examples 1-5, in which the Cu-Ga-K-F region did not exist, the number of occurrence of the abnormal discharge was high; and sputtering was not performed stably. Particularly, in Comparative Examples 4 and 5, in which the grain size of the KF raw material powder was too large; and the content of the K component was too high, the sputtering device was shut down during high-power sputtering. In addition, in Comparative Examples 1, 4, and 5, uniformity of the K component in the deposited Cu-Ga film was deteriorated.

Contrary to that, in Examples 1-13 of the present invention, in which the Cu-Ga-K-F region do exist, the number of occurrence of the abnormal discharge was low; and sputtering was performed stably. In addition, it was confirmed that uniformity of the K component in the deposited Cu-Ga film was improved.

INDUSTRIAL APPLICABILITY

It is possible to produce the CIGS solar cell having high energy conversion efficiency with high production efficiency.

REFERENCE SIGNS LIST

    S01: Cu-Ga alloy powder preparing process
    S02: Mixing and crushing process
    S03: Sintering process
    S04: Machining process

**Claims**

1.  A Cu-Ga sputtering target made of a composition consisting of: as metal components excluding fluorine, 5 atomic% or more and 60 atomic% or less of Ga and 0.01 atomic% or more and 5 atomic% or less of K; and the Cu balance containing inevitable impurities, wherein
    the Cu-Ga sputtering target has a region containing 5 mass% or more of Cu, 5 mass% or more of Ga, 5 mass% or more of K, and 5 mass% or more of F, in an atomic mapping image by a wavelength separation X-ray detector.

2.  The Cu-Ga sputtering target according to Claim 1, wherein
    the region containing Cu, Ga, K, and F has a compound phase of: K; one of or both of Cu and Ga; and F.

3.  The Cu-Ga sputtering target according to Claim 1 or 2, wherein the region containing Cu, Ga, K, and F disperses in a grain boundary of a Cu-Ga matrix.

4.  The Cu-Ga sputtering target according to any one of Claims 1 to 3, wherein the Cu-Ga matrix includes a KF single phase, and an abundance ratio X of the KF single phase relative to an entire amount of KF in the Cu-Ga sputtering target is $0\% < X \leq 70\%$.

5.  A Cu-Ga sputtering target production method for producing the Cu-Ga sputtering target according to any one of Claims 1 to 4, the method comprising the step of sintering a raw material powder by heating, wherein
    the raw material powder is a mixed powder, in which: a first Cu-Ga alloy powder containing 43 atomic% or more and 66 atomic% or less of Ga; a KF raw material powder; and one of or both of a second Cu-Ga alloy powder containing more than 0 atomic% and less than 43 atomic% of Ga and a Cu powder, are mixed so as to obtain a composition consisting of: as metal components excluding fluorine, 5 atomic% or more and 60 atomic% or less of Ga and 0.01 atomic% or more and 5 atomic% or less of K; and the Cu balance containing inevitable impurities, and
    a Cu-Ga-K-F region containing 5 mass% or more of Cu, 5 mass% or more of Ga, 5 mass% or more of K, and 5 mass% or more of F is formed by reacting a liquid phase produced from the first Cu-Ga alloy powder and the KF raw material powder.

6.  The Cu-Ga sputtering target production method according to Claim 5, wherein an oxygen concentration of the first Cu-Ga alloy powder is 1000 ppm or less.

7.  The Cu-Ga sputtering target production method according to Claim 5 or 6, wherein an average grain size of the first Cu-Ga alloy powder in the raw material powder is in a range of 5 μm or more and 50 μm or less; and an average grain size of the KF raw material powder is in the range of 5 $\mu$m or more and 500 $\mu$m or less.

8. The Cu-Ga sputtering target production method according to any one of Claims 5 to 7, wherein the raw material powder is kept at a temperature, at which a liquid phase is formed from the first Cu-Ga alloy powder, for 15 minutes or more in the step of sintering.

**Patentansprüche**

1. Cu-Ga-Sputtertarget, hergestellt aus einer Zusammensetzung bestehend aus: als Metallkomponenten außer Fluor, 5 Atom-% oder mehr und 60 Atom-% oder weniger Ga und 0,01 Atom-% und 5 Atom-% oder weniger K; und Rest Cu, enthaltend unvermeidbare Verunreinigungen, worin
das Cu-Ga-Sputtertarget einen Bereich aufweist, der 5 Masse-% oder mehr Cu, 5 Masse-% oder mehr Ga, 5 Masse-% oder mehr K und 5 Masse-% oder mehr F in einem Atom-Mapping-Bild mit einem Wellenlängentrennungs-Röntgendetektor aufweist.

2. Cu-Ga-Sputtertarget gemäß Anspruch 1, worin der Bereich, der Cu, Ga, K und F enthält, eine Mischphase von: K; einem oder beiden von Cu und Ga; und F aufweist.

3. Cu-Ga-Sputtertarget gemäß Anspruch 1 oder 2, worin der Bereich, der Cu, Ga, K und F enthält, in einer Korngrenze einer Cu-Ga-Matrix dispergiert ist.

4. Cu-Ga-Sputtertarget gemäß irgendeinem der Ansprüche 1 bis 3, worin die Cu-Ga-Matrix eine KF-Einzelphase enthält und worin die Auftretungshäufigkeit X der KF-Einzelphase relativ zur Gesamtmenge von KF in dem Cu-Ga-Sputtertarget 0%<X≤70 % beträgt.

5. Cu-Ga-Sputtertarget-Herstellungsverfahren zur Herstellung des Cu-Ga-Sputtertargets gemäß irgendeinem der Ansprüche 1 bis 4, worin das Verfahren den Schritt des Sinterns eines Ausgangsmaterialpulvers durch Erwärmen umfasst, worin
das Ausgangsmaterialpulver ein gemischtes Pulver ist, worin: ein erstes Cu-Ga-Legierungspulver, enthaltend 43 Atom-% oder mehr und 66 Atom-% oder weniger Ga; ein KF-Ausgangsmaterialpulver; und eines oder beides von einem zweiten Cu-Ga-Legierungspulver, enthaltend mehr als 0 Atom-% und weniger als 43 Atom-% Ga, und einem Cu-Pulver vermischt werden, um so eine Zusammensetzung zu erhalten, die besteht aus: als Metallkomponenten außer Fluor 5 Atom-% oder mehr und 60 Atom-% oder weniger Ga und 0,01 Atom-% oder mehr und 5 Atom-% oder weniger K; und Rest Cu, enthaltend unvermeidbare Verunreinigungen, und
ein Cu-Ga-K-F-Bereich, enthaltend 5 Masse-% oder mehr Cu, 5 Masse-% oder mehr Ga, 5 Masse-% oder mehr K und 5 Masse-% oder mehr F, gebildet wird durch Umsetzen einer flüssigen Phase, die aus dem ersten Cu-Ga-Legierungspulver hergestellt ist, mit dem KF-Ausgangsmaterialpulver.

6. Cu-Ga-Sputtertarget-Herstellungsverfahren gemäß Anspruch 5, worin die Sauerstoffkonzentration des ersten Cu-Ga-Legierungspulvers 1.000 ppm oder weniger beträgt.

7. Cu-Ga-Sputtertarget-Herstellungsverfahren gemäß Anspruch 5 oder 6, worin die mittlere Korngröße des ersten Cu-Ga-Legierungspulvers in dem Ausgangsmaterialpulver im Bereich von 5 $\mu$m oder mehr und 50 $\mu$m oder weniger liegt; und worin die mittlere Korngröße des KF-Ausgangsmaterialpulvers im Bereich von 5 $\mu$m oder mehr und 500 $\mu$m oder weniger liegt.

8. Cu-Ga-Sputtertarget-Herstellungsverfahren gemäß irgendeinem der Ansprüche 5 bis 7, worin im Schritt des Sinterns das Ausgangsmaterialpulver für 15 Minuten oder mehr bei einer Temperatur gehalten wird, bei der aus dem ersten Cu-Ga-Legierungspulver eine flüssige Phase gebildet wird.

**Revendications**

1. Cible de pulvérisation cathodique en Cu-Ga composée d'une composition constituée de : en tant que composants métalliques excluant le fluor, 5 % atomique ou plus et 60 % atomique ou moins de Ga et 0,01 % atomique ou plus et 5 % atomique ou moins de K ; et le reste composé de Cu contenant des impuretés inévitables, dans laquelle la cible de pulvérisation cathodique en Cu-Ga a une région contenant 5 % en masse ou plus de Cu, 5 % en masse ou plus de Ga, 5 % en masse ou plus de K, et 5 % en masse ou plus de F, dans une image de cartographie atomique par détecteur de rayons X par dispersion de longueur d'onde.

2. Cible de pulvérisation cathodique en Cu-Ga selon la revendication 1, dans laquelle
la région contenant Cu, Ga, K et F a une phase composée de : K ; un ou les deux parmi Cu et Ga ; et F.

3. Cible de pulvérisation cathodique en Cu-Ga selon la revendication 1 ou 2, dans laquelle la région contenant Cu, Ga, K, et F se disperse dans un joint de grains d'une matrice Cu-Ga.

4. Cible de pulvérisation cathodique en Cu-Ga selon l'une quelconque des revendications 1 à 3, dans laquelle la matrice Cu-Ga inclut une phase unique KF, et un rapport des teneurs X entre la phase unique KF par rapport à une quantité totale de KF dans la cible de pulvérisation cathodique en Cu-Ga de 0 %<X≤70 %.

5. Procédé de production d'une cible de pulvérisation cathodique en Cu-Ga pour produire la cible de pulvérisation cathodique en Cu-Ga selon l'une quelconque des revendications 1 à 4, le procédé comprenant l'étape de frittage d'une poudre de matières premières par chauffage, dans lequel
la poudre de matières premières est une poudre mixte, dans laquelle : une première poudre d'alliage Cu-Ga contenant 43 % atomique ou plus et 66 % atomique ou moins de Ga ; une poudre de matières premières de KF ; et une ou les deux parmi une seconde poudre d'alliage Cu-Ga contenant plus de 0% atomique et moins de 43% atomique de Ga et une poudre de Cu, sont mélangées de manière à obtenir une composition constituée de : en tant que composants métalliques excluant le fluor, 5 % atomique ou plus et 60% atomique ou moins de Ga et 0,01% atomique ou plus et 5% atomique ou moins de K ; et le reste composé de Cu contenant des impuretés inévitables, et une région Cu-Ga-K-F contenant 5 % en masse ou plus de Cu, 5 % en masse ou plus de Ga, 5 % en masse ou plus de K, et 5 % en masse ou plus de F est formée par réaction d'une phase liquide produite à partir de la première poudre d'alliage Cu-Ga et de la poudre de matières premières de KF.

6. Procédé de production d'une cible de pulvérisation cathodique en Cu-Ga selon la revendication 5, dans lequel une concentration en oxygène de la première poudre d'alliage Cu-Ga est inférieure ou égale à 1 000 ppm.

7. Procédé de production d'une cible de pulvérisation cathodique en Cu-Ga selon la revendication 5 ou 6, dans lequel une granulométrie moyenne de la première poudre d'alliage Cu-Ga dans la poudre de matières premières se situe dans une plage de 5 $\mu$m ou plus et 50 $\mu$m ou moins; et une granulométrie moyenne de la poudre de matières premières de KF se situe dans la plage de 5 $\mu$m ou plus et 500 $\mu$m ou moins.

8. Procédé de production d'une cible de pulvérisation cathodique en Cu-Ga selon l'une quelconque des revendications 5 à 7, dans lequel la poudre de matières premières est gardée à une température, à laquelle une phase liquide est formée à partir de la première poudre d'alliage Cu-Ga, pendant 15 minutes ou plus dans l'étape de frittage.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011083647 A

- JP 4793504 B